## Europäisches Patentamt
## European Patent Office
## Office européen des brevets

(11) Numéro de publication: **0 235 029**
**A1**

## DEMANDE DE BREVET EUROPEEN

(21) Numéro de dépôt: 87400340.3

(22) Date de dépôt: 17.02.87

(51) Int. Cl.⁴: **H 01 L 27/14**
H 01 L 31/08

(30) Priorité: 25.02.86 FR 8602583

(43) Date de publication de la demande:
02.09.87 Bulletin 87/36

(84) Etats contractants désignés: DE GB NL

(71) Demandeur: **THOMSON-CSF**
**173, Boulevard Haussmann**
**F-75379 Paris Cedex 08 (FR)**

(72) Inventeur: **Razeghi, Manijeh**
**Thomson-CSF SCPI-19, avenue de Messine**
**F-75008 Paris (FR)**

**Decoster, Didier**
**Thomson-CSF SCPI-19, avenue de Messine**
**F-75008 Paris (FR)**

(74) Mandataire: **Lepercque, Jean et al**
**THOMSON-CSF SCPI 19, avenue de Messine**
**F-75008 Paris (FR)**

(54) Tête de détection optique réalisée en optique intégrée et procédé de réalisation.

(57) Tête de détection optique réalisée en optique intégrée comprenant une photorésistance en GaInAs (5) réalisé sur des couches de GaAs (couches 1, 2, 3). Un transistor à effet de champ (20) est réalisé sur les mêmes couches de GaAs (1, 2, 3) pour obtenir une amplification du courant de détection.

Une telle tête de détection trouve des applications préférentielles dans les domaines de détection des rayonnements lumineux à des longueurs d'ondes comprises entre 1,3 et 1,5 μm.

Fig.1

EP 0 235 029 A1

**0 235 029**

**Description**

## TETE DE DETECTION OPTIQUE REALISEE EN OPTIQUE INTEGREE ET PROCEDE DE REALISATION

L'invention concerne une tête de détection optique réalisée en optique intégrée et son procédé de réalisation. Elle concerne plus particulièrement un détecteur optique et un préamplificateur réalisés de façon monolithique pour être applicable notamment aux longueurs d'ondes de transmission par fibres optiques.

Le développement des télécommunications par fibres optiques suppose la réalisation de détecteurs optiques adaptés aux longueurs d'ondes situées entre 1,3 $\mu m$ et 1,55 $\mu m$. Afin d'améliorer la sensibilité de la chaîne de détection, ce détecteur doit être associé à un amplificateur faible bruit. Aux fréquences élevées, supérieures à 1GHz, l'intégration monolithique du préamplificateur avec le détecteur est souhaitable. Elle permet notamment de limiter les effets parasites non contrôlés et indésirables, tels que les capacités parasites. Il est bien connu que les meilleurs transistors pour l'amplification hyperfréquence à faible bruit sont les transistors à effet de champ (TEC) réalisés sur arséniure de gallium (GaAs). Une intégration du photodétecteur avec un amplificateur à transistors à effet de champ sur AsGa serait un objectif à atteindre. Mais la valeur de la bande interdite de l'arséniure de gallium (1,45 eV) ne permet pas une détection à des longueurs d'onde supérieures à 0,85 $\mu m$. Par contre, à cause de la valeur de sa bande interdite (0,75 eV), l'arséniure de gallium et d'indium (GaInAs), dans la proportion de 47% de gallium et 53% d'indium, est particulièrement bien adapté à la détection aux longueurs d'onde de 1,3 $\mu m$ et 1,55 $\mu m$. Cependant l'arséniure de gallium et d'indium, d'une part, et l'arséniure de gallium d'autre part, sont des matériaux désadaptés en mailles cristallines. En conséquence, on ne dispose, jusqu'à ce jour, pour réaliser une chaîne de détection optique à 1,3 $\mu m$ et 1,55 $\mu m$ que :

- soit de composants photodétecteurs à base de $Ga_{0,47}In_{0,53}As$ épitaxiés sur un substrat de phosphore d'indium (InP) dont la maille cristalline est adaptée à celle du $Ga_{0,47}In_{0,53}As$.

- soit de transistors ou de circuits intégrés réalisés sur arséniure de gallium (GaAs) permettant une amplification en hyperfréquences, les différences de substrat entre un photodétecteur réalisé en phosphore d'indium (InP) et l'amplificateur en arséniure de gallium (GaAs), ne permettant pas une intégration monolithique du photodétecteur avec l'amplificateur.

C'est pourquoi l'invention concerne une tête de détection optique fonctionnant à des longueurs de 1,3 $\mu m$ et 1,55 $\mu m$ et réalisable en conception intégrée monolithique.

L'invention concerne donc une tête de détection optique réalisée en optique intégrée comprenant une photorésistance et un amplificateur connecté à cette photorésistance, caractérisée en ce que :

- l'élément photorésistant comporte une couche d'arséniure de gallium et d'indium ($Ga_xIn_{(1-x)}As$) dont la proportion en gallium est de x et celle d'indium de 1-x avec x compris entre 0 et 0,47 de façon à ce que le paramètre de maille de ce matériau soit sensiblement égal à celui du phosphore d'indium, ladite couche d'arséniure de gallium et d'indium étant déposée sur une couche de semiconducteur en arséniure de gallium (GaAs) non intentionnellement dopé ;

- l'amplificateur comporte un transistor à effet de champ réalisé sur la couche d'arséniure de gallium (GaAs) non intentionnellement dopé.

L'invention concerne également le procédé de réalisation d'une tête de détection optique selon la revendication 1, caractérisé en ce qu'il comporte les étapes successives suivantes :

- une première étape de réalisation sur un substrat semi-isolant d'une première couche d'arséniure de gallium non intentionnellement dopé, d'une deuxième couche d'arséniure de gallium faiblement dopé, d'une troisième couche d'arséniure de gallium fortement dopé, d'une quatrième couche d'arséniure de gallium et d'indium ($Ga_xIn_{(1-x)}As$) ;

- une deuxième étape de découpe, dans la quatrième couche d'arséniure de gallium et d'indium, d'une mésa ;

- une troisième étape de découpe, dans les trois couches d'arséniure de gallium, d'un emplacement nécessaire à la réalisation de la tête de détection ;

- une quatrième étape de réalisation, sur la quatrième couche d'arséniure de gallium et d'indium, de contacts ohmiques et de contacts ohmiques sur la source et le drain du transistor , un matériau isolant étant en outre déposé pour isoler les couches d'arséniure de gallium :

- une cinquième étape d'usinage, dans les couches d'arséniure de gallium, entre les contacts ohmiques de source et de drain, d'un creux dont le fond constitue la porte du transistor :

- une sixième étape de réalisation, dans le fond du creux d'une électrode de porte ;

- une septième étape de réalisation de connexions entre l'un des contacts ohmiques de l'élément photoconducteur et le contact de source d'une part et, d'autre part, entre l'autre contact ohmique de l'élément photoconducteur et l'électrode de porte.

Les différents objets et caractéristiques de l'invention apparaîtront plus clairement dans la description qui va suivre faite en se reportant aux figures annexées qui représentent :

- la figure 1, un exemple de réalisation de la tête de détection optique selon l'invention ;
- la figure 2, le schéma électrique de la tête de détection optique selon l'invention ;
- les figures 3 et 4, des variantes de réalisation de la tête de détection optique selon l'invention ;
- la figure 5, un schéma électrique équivalent de la tête optique selon l'invention ;
- la figure 6, une autre variante de réalisation de la tête optique selon l'invention ;

2

# 0 235 029

- la figure 7, une vue en coupe détaillée de la tête optique de la figure 1 ;
- la figure 8, une vue de dessus de la tête optique selon l'invention ;
- les figures 9 à 14, différentes étapes du procédé de réalisation de la tête de détection optique selon l'invention.

Nous allons tout d'abord décrire une tête de détection optique selon l'invention. Cette tête, complètement intégrée monolithiquement, est prévue pour fonctionner aux longueurs d'onde inférieures ou égale à 1,6 µm. Elle comprend une photorésistance GaInAs associée à un transistor à effet de champ sur GaAs. La photo-résistance en GaInAs permet la photodétection des signaux optiques aux longueurs d'onde inférieures ou égales à 1,6 µm (1,3 µm et 1,55 µm notamment) ; le transistor à effet de champ sur GaAs a une fonction de préamplificateur.

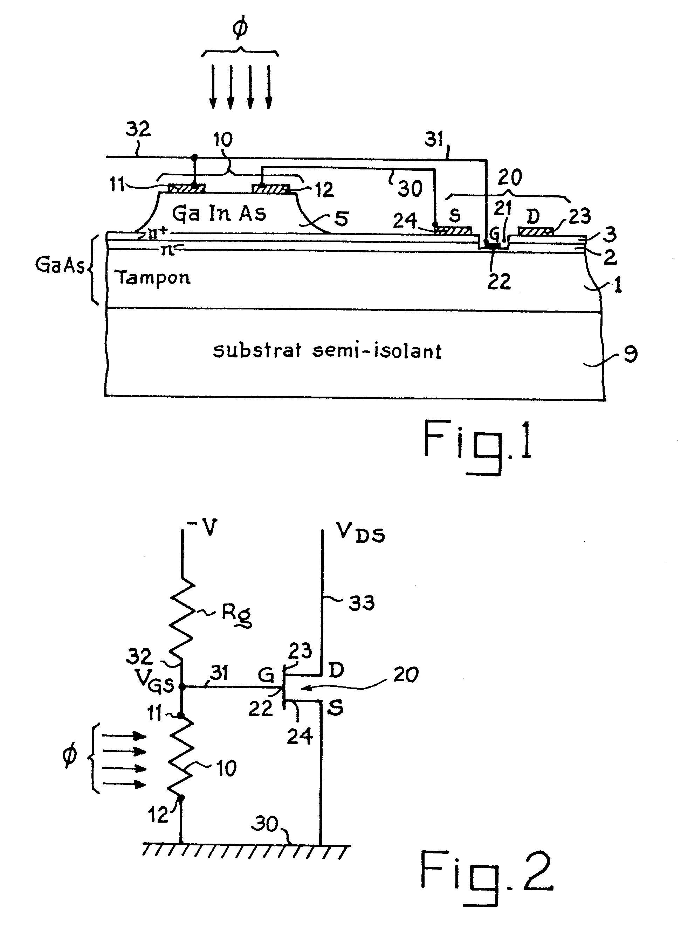

Une telle tête de détection optique est représentée sur la figure 1. Elle comporte, sur un substrat semi-isolant 9 :
- une couche 1 d'arséniure de gallium (GaAs) non intentionnellement dopé,
- une couche 2 d'arséniure de gallium faiblement dopé (n),
- une couche 3 d'arséniure de gallium fortement dopé (n+) comparativement à la couche 2.

Une structure en forme de mésa 5 en arséniure de gallium et d'indium est réalisée sur la couche 3 d'arséniure de gallium (GaAs) fortement dopé. La structure mésa 5 comporte deux contacts métalliques ou électrodes 11 et 12. L'arséniure de gallium et d'indium présente la propriété de devenir conducteur sous l'action d'un faisceau lumineux. Sa composition sera choisie telle que dans $Ga_xIn_{(1-x)}As$, la valeur de x soit comprise entre 0 et 0,47. Plus précisément, pour avoir un bon fonctionnement aux longueurs d'ondes de 1,3 µm et 1,55 µm, on prendra pour x la valeur 0,47 ce qui donnera une formule telle que $Ga_{0,47}In_{0,53}As$. La mésa 5 et les électrodes 11 et 12 constituent donc l'élément photoconducteur 10 de la tête de détection optique. La distance séparant les deux électrodes 11 et 12 détermine la sensibilité de l'élément photoconducteur.

Par ailleurs, dans les couches 2 et 3 d'arséniure de gallium dopé n et n+ est réalisé un transistor à effet de champ. Pour cela dans une cavité 21 des couches 2 et 3 se trouve la porte 22 du transistor en contact avec la couche 2 d'arséniure de gallium faiblement dopé.

De part et d'autre de la cavité 21 se trouvent la source 24 et le drain 23 sur la couche 3 d'arséniure de gallium fortement dopé n+.

Une connexion électrique 30 connecte l'électrode 12 de l'élément photoconducteur 10 à la source du transistor 20.

Une connexion électrique 31 connecte l'autre électrode 11 de l'élément photoconducteur 10 à la porte 22 du transistor 20.

L'élément photoconducteur 10 est éclairé par un flux lumineux indiqué par les flèches φ de la figure 1. de la figure 1.

Le détecteur optique ainsi décrit possède un schéma électrique équivalent tel que représenté par la figure 2.

Sur cette figure on retrouve l'élément photoconducteur 10 éclairée par le flux φ, le transistor à effet de champ 20. La porte 22 du transistor est connectée directement à une borne de l'élément photoconducteur 10 par une connexion 31. La source 24 est connectée à l'autre borne de l'élément photoconducteur 10 par une terre désignée par la référence 30 puisqu'elle remplit le rôle de la connexion 30 de la figure 1.

De plus, le drain 23 est alimenté par une source de tension $V_{DS}$. Le courant drain $I_D$ du transistor à effet de champ est fixé à une valeur constante donnée par la tension de polarisation continue du drain $V_d$. La porte 22 est polarisée par une source de tension -V et une résistance de polarisation Rg connectées par une connexion 32 à la connexion 31.

De ce fait, selon l'état de conduction de l'élément photoconducteur 10, qui varie en fonction de l'intensité lumineuse reçue, le potentiel $V_{GS}$ polarisant la porte 22, prend une valeur particulière, et détermine l'état de conduction du transistor à effet de champ 20.

Le schéma électrique de la figure 2 et de ce fait la tête de détection optique de la figure 1 constitue un étage d'amplification dont le fonctionnement dépend de l'élément photoconducteur 10.

Les électrodes 11 et 12 sont obtenues par le dépôt, directement sur le GaInAs, de deux contacts ohmiques constitués d'un eutectique Or-Germanium. Dans les exemples de réalisation représentés sur les figures, la photorésistance a une structure simple telle que la distance interélectrode est égale par exemple à 20 µm et la largeur des électrodes vaut 80 µm ; mais d'autres structures, interdigitées par exemple, peuvent être prévues, et ne modifient en rien le principe du dispositif. Au contraire une structure interdigitée permet d'améliorer la sensibilité de l'élément photoconducteur 10.

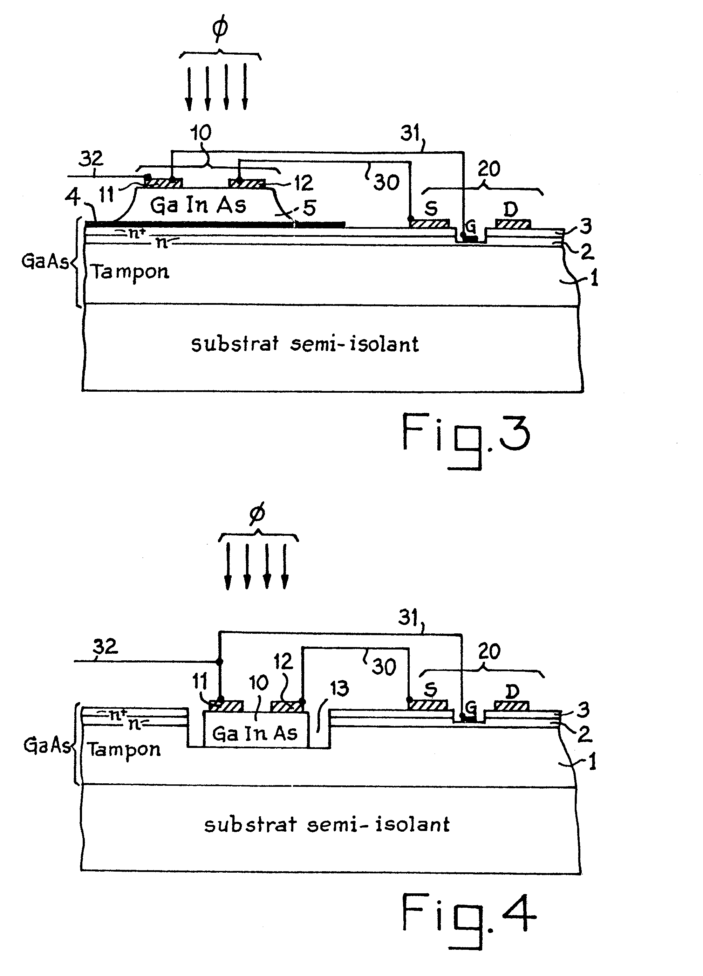

La tête de détection optique selon l'invention peut se présenter avec une couche de phosphore d'indium (InP) située entre la mésa 5 et la couche 3 d'arséniure de gallium (GaAs). Une telle tête de détection est représentée en figure 3 où l'on trouve la couche 4 de phosphore d'indium. Cette couche de phosphore d'indium a une utilité dans le cadre de la fabrication de la mésa 5 dont le procédé de fabrication sera décrit ultérieurement.

Selon une autre variante de réalisation représentée en figure 4, les couches d'arséniure de gallium 1, 2 et 3 présentent un creux 13 dans lequel se trouve l'élément photoconducteur 10 en contact direct avec la couche d'arséniure de gallium 1.

Le transistor à effet de champ 20 se présente de la même façon que sur la figure 1 et est connecté de la même façon à l'élément photoconducteur 10.

Cette variante de réalisation présente l'intérêt d'augmenter la résistance d'obscurité de l'élément photoconducteur 10 c'est-à-dire la résistance en l'absence d'éclairement de l'élément photoconducteur. Dans le cas des figures 1 et 2, la couche d'arséniure de gallium dopé n+a pour effet de diminuer la résistance d'obscurité de l'élément photoconducteur 10 en matériau GaInAs. Pour éliminer cet effet parasite la solution représentée en figure 4 consiste à faire croître l'arséniure de gallium et d'indium (GaInAs) directement sur la couche 1 d'arséniure de gallium non intentionnellement dopé à l'endroit où l'on a l'intention de réaliser l'élément photoconducteur 10.

Ce mode de réalisation ne change rien au principe du dispositif. Il permet cependant une augmentation importante de ses performances, notamment en ce qui concerne l'amplifiation du photocourant, ainsi que nous le rappelerons dans les explications qui vont suivre concernant les caractéristiques et les performances de la tête optique de l'invention.

A titre d'exemple de réalisation les différentes couches 1, 2, 3 et 5 dans lesquelles est fabriquée la tête optique ont les épaisseurs et les concentrations en dopage indiquées dans le tableau ciðessous :-

| Numéro des couches | Nature du matériau | Epaisseur | Concentration de dopage |
|---|---|---|---|
| 5 | Arséniure de gallium et d'indium GaInAs | $\geq 1 \mu m$ | Non intention- nellement dopé |
| 3 | Arséniure de gallium Dopé n+ GaAs | 2000 Å | $10^{18}$ atomes/cm$^3$ |
| 2 | Arséniure de gallium Dopé GaAs | 2000 Å | $10^{17}$ atomes/cm$^3$ |
| 1 | Arséniure de gallium GaAs | 4 $\mu m$ | $10^{14}$ atomes/cm$^3$ |

Dans la variante de réalisation de la figure 2 l'épaisseur de la couche 4 de phosphore d'indium InP, dans le cadre d'une telle réalisation, est supérieure à 2000 angstroem.

L'arséniure de gallium et d'indium est constitué d'une proportion de 47% de gallium et 53% d'indium ce qui s'écrit : $GA_{0,47} IN_{0,53} As$.

Avec un élément photoconducteur 10 réalisé sur la couche 3 d'arséniure de gallium tel que représenté en figure 1 et avec des couches telles que décrites précédemment, on obtient une tête de détection ayant les caractéristiques suivantes.

Comme mentionné précédemment, la résistance d'obscurité de l'élément photoconducteur est relativement faible (de l'ordre de 50 ohms).

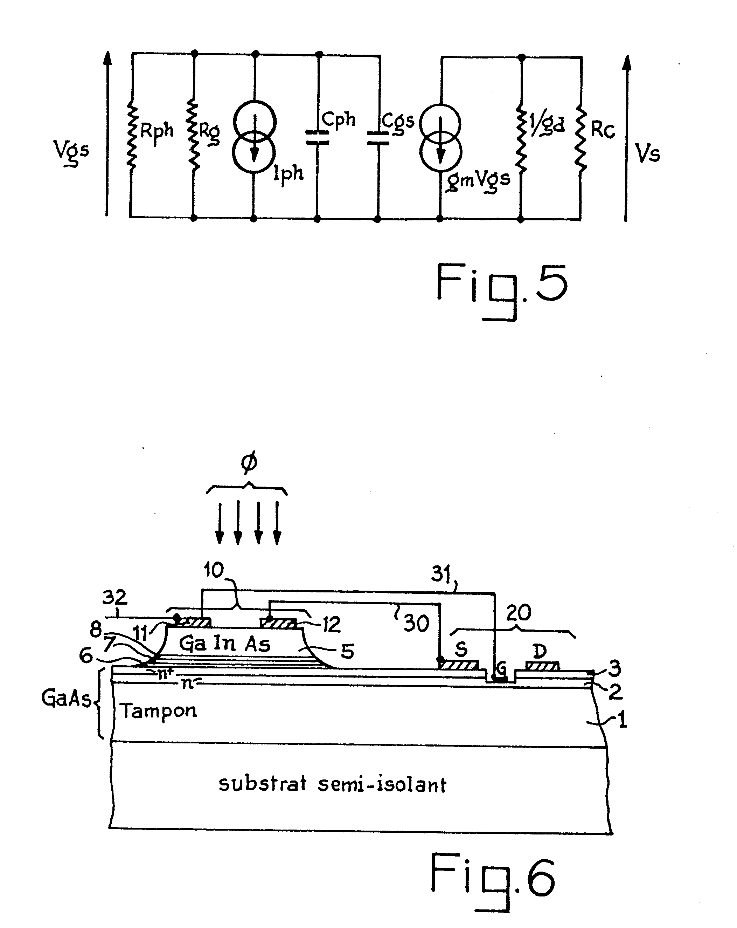

Le schéma électrique équivalent de la tête de lecture est représenté en figure 5. Dans cette figure, les différentes références représentent

$I_{ph}$ : le photocourant délivré par la photorésistance

$R_{ph}$ : la résistance interne de la photorésistance

$R_G$ : la résistance de polarisation de la grille du transistor (et en même temps de la photorésistance)

$C_{ph}$: la capacité interne de la photorésistance

$C_g$ : la capacité de grille du transistor

$g_m$ : la transconductance du transistor

$V_{gs}$ : la tension grille-source

$G_d$ : la conductance vue du côté drain du transistor

$R_c$ : la résistance de charge du transistor

Le photocourant Iph délivré par la photorésistance se déduit du gain $G_R$ de la photorésistance, qui est défini comme le nombre d'électrons collectés dans le circuit extérieur par photon incident, soit :

$$G_R = \frac{I_{ph}}{P_L} \times \frac{h\ \nu}{q}$$

où $P_L$ est la puissance lumineuse incidente, h l'energie d'un photon,

q la charge d'un électron. Ce gain $G_R$ s'exprime à l'aide de la durée de vie $\tau_v$ des paires électron-trou et du temps de transit $\tau_t$ des électrons. Pour un signal optique modulé à la pulsation $\omega$, le gain de la photorésistance se met approximativement sous la forme :

$$G_R \# \frac{\tau_v}{\tau_t} \times \frac{1}{\sqrt{1 + \omega^2 \tau\nu^2}}$$

Nos mesures ont montré que les photorésistances de distances interélectrodes 20 μm, réalisées avec des matériaux contraints GaInAs-GaAs, ont des gains pouvant atteindre $10^3$ pour des tensions de polarisation de 2V. Il en résulte que les durées de vie des paires électron-trou sont voisines de quelques centaines de manosecondes, et que, pour des fréquences d'utilisation voisines ou supérieures à 1 MHz, le gain de la photorésistance s'exprime comme :

$$G_R \# \frac{1}{\omega \tau_t}$$

soit un produit gain-bande voisin de 1/2 $\pi\tau_t$.

La mobilité des électrons dans le GaInAs contraint a été mesuré de l'ordre de 5000 $cm^2$/V.s. à 300° K. Pour une tension de polarisation de 2 V, le produit gain-bande d'une photorésistance de 20 μm de distance interélectrode sera donc proche de 0,5 GHz, valeur tout à fait compatible avec celle obtenue expérimentalement. Le gain de la photorésistance est multiplié par le gain en courant $G_c$ du transistor, qui, après analyse du circuit électrique équivalent, se met sous la forme :

$$G_c = \frac{g_m R_{eq}}{\sqrt{1 + \omega^2 R_{eq}^2 C_{eq}^2}}$$

où

$$\frac{1}{R_{eq}} = \frac{1}{R_{ph}} + \frac{1}{R_G}$$

et $C_{eq} = C_{ph} + C_g$

Nos différentes caractérisations ont conduit à des valeurs de $R_{eq}$ et de la fréquence de coupure du circuit intégré voisines respectivement de 50 Ω et de quelques GHz. Notons que la fréquence de coupure est due essentiellement à la capacité $C_{ph}$ de la grille du transistor. Pour des fréquences inférieures ou voisines du gigahertz, le gain total $G_T$ de la tête optique s'écrira donc :

$$G_T = G_R \; G_C \# \frac{g_m \; R_{eq}}{\omega \tau_t}$$

Ce résultat montre que le gain en courant est proportionnel au $g_m$ du transistor et explique le choix des dimensions du transistor dont la grille de 2 μm × 900 μm conduit à un $g_m$ supérieur à 50 mS. Le circuit intégré réalisé est donc caractérisé par un produit gainbande compris entre 1 GHz et 1,5 GHz. Ces performances peuvent, bien sûr, être améliorées, par l'utilisation de photorésistances à distances interélectrodes très courtes (1 à qq μm), à résistances internes plus grandes (qq K Ω ) et de transistors à $g_m$ plus grands (interdigités par exemple). Un procédé pour obtenir des résistances internes plus grandes a déjà été mentionné précédemment. Il s'agit de faire croître du GaInAs sur la couche tampon du GaAs. Les performances de la tête optique devraient dans ce cas pouvoir être augmentées d'un facteur 10.

Un autre facteur déterminant dans les performances du dispositif est le bruit. En effet, la croissance de matériau contraint peut contribuer à la présence de défauts ou pièges à l'origine d'un bruit de piégeage-dépiégeage important. Nos expériences montrent l'existence d'un important bruit en 1/f pour des fréquences inférieures à 100 MHz. Au-delà, le bruit est quasiment identique au bruit thermique de Nyquist. Ce résultat est très important. Il montre que les potentialités de la tête optique intégrée monolithique, associant une photorésistance à un TEC GaAs, prévues comparables, voire supérieures à celles obtenues avec des montages hybrides classiques, ne sont pas, dans la bande 100 MHz-5GHz des télécommunications optiques, dégradées par l'utilisation de matériaux contraints.

Comme indiqué précédemment la composition de la couche 5 d'arséniure de gallium et d'indium est réalisée avec une proportion de 47% de gallium et 53% d'indium.

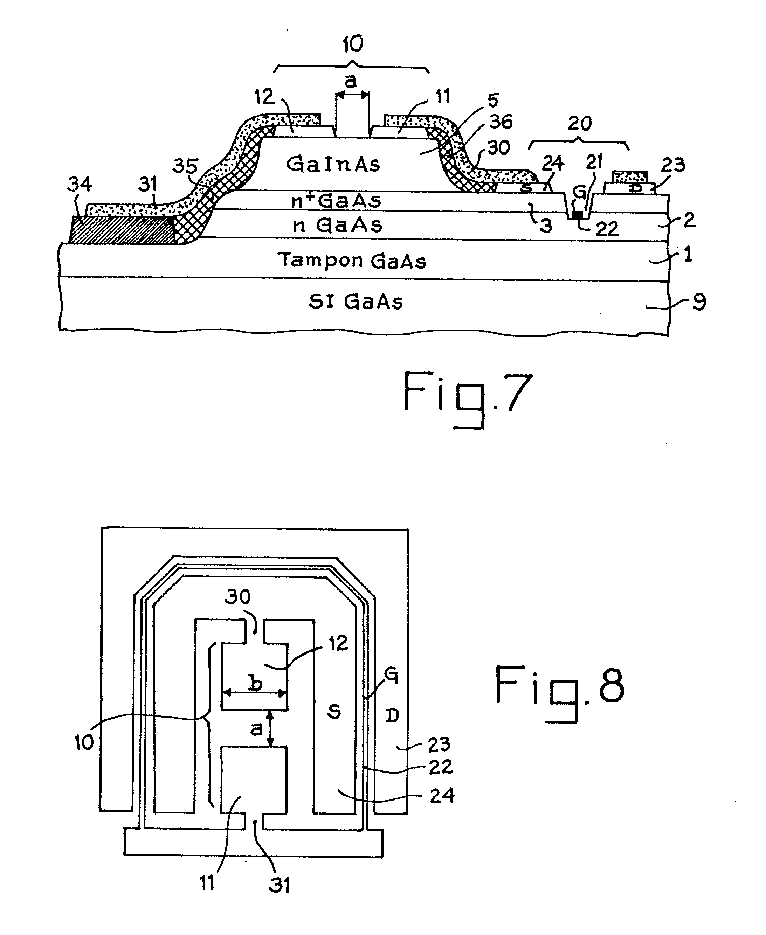

Cependant selon une variante de réalisation de l'invention représentée sur la figure 6, la couche 5 peut être séparée de la couche 3 d'arséniure de gallium par plusieurs couches d'arséniure de gallium et d'indium dont la composition en gallium et en indium est de x% pour le gallium et $(100 - x)$% pour l'indium. L'indice x prend alors différentes valeurs croissant de 47% à 100% en partant de la couche 6 la plus proche de la couche 5 et en parcourant les différentes couches 7 et 8 jusqu'à la couche 3. Chacune de ces couches intermédiaires 6, 7 et 8 a une épaisseur d'environ 100 angstroem. On a alors une succession de couches suivantes avec des épaisseurs de couches indiquées à titre d'exemple :

$$\underbrace{GA_{0,47}In_{0,53}As}_{e\,\geqslant\,1\;\mu m}\Big/\underbrace{Ga_xIn_{(1-x)}AS\Big/Ga_xIn_{(1-x)}As\Big/Ga_xIn_{(1-x)}As\Big/}_{\text{avec x variant de 0,47 à 1 ; }(e\simeq100\text{ A})}$$

$$\Big/\underbrace{GaA_s(n^+)}_{e\simeq2000\text{ Å}}\Big/\underbrace{GaAs(n)}_{2000\text{ Å}}\Big/\underbrace{GaAs\text{ tampon}}_{e\simeq4\,\mu m}\Big/GaAs\quad(S.I.)$$

Une telle structure permet d'éviter le risque d'une désadaptation entre la couche 5 d'arséniure de gallium et d'indium (GaInAs) et la couche 3 d'Arséniure de gallium.

La figure 7 représente une vue détaillée de l'exemple de réalisation de la figure 1.

On retrouve donc sur cette figure, le substrat 9, la couche tampon 1 d'arséniure de gallium, la couche 2 d'arséniure de gallium dopé n, la couche 3 d'arséniure de gallium dopé n+, la couche 5 d'arséniure de gallium et d'indium avec laquelle est réalisé l'élément photoconducteur 10. Les flancs de l'élément photoconducteur 10 et des couches 2 et 3 ont été recouverts de matériau isolant 35 et 36.

Les électrodes 11 et 12 sont réalisées sous forme de deux contacts ohmiques en un alliage de métaux précieux tel que AuGeNi. L'épaisseur de ces électrodes est d'environ 2000 angstroem. Elles sont séparées d'environ 20 µm et ont une largeur de 80 µm délimitant une aire photosensible d'environ 20 µm × 80 µm.

Pour obtenir une bonne amplification à des fréquences atteignant plusieurs gigahertz, le transistor à effet de champ 20 possède une porte de 2 µm × 900 µm. Cette porte peut être réalisée par des couches de titane (500 angstroem), platine (300 angstroem), titane (300 angstroem) et or (2000 angstroem).

Comme représenté en figure 8, le transistor à effet de champ 20 entoure l'élément photoconducteur 10. Sur cette figure on a représenté les électrodes et les connexions. On y retrouve donc l'élément photoconducteur 10 avec ces électrodes 11 et 12 séparées par un espace de largeur a. Les électrodes 11 et 12 ont une largeur b. Les dimensions a et b déterminent l'aire photosensible de l'élément photoconducteur 10.

L'électrode de source 24 entoure sur trois côtés l'élément photoconducteur 10 et est connectée par une connexion 30 à l'électrode 10 de l'élément photoconducteur.

La porte 22 entoure la source 24 et possède une connexion 31 connectant ces deux extrémités à l'autre électrode 11 de l'élément photoconducteur 10.

Enfin le drain 23 entoure la porte 22.

Les connexions 30 et 31 entre le transistor 20, constitué de la source 24, de la porte 22 et du drain 23, et l'élément photoconducteur 10 sont réalisées à l'aide de matériaux métalliques tels que de l'or ou de l'AuGeNi ayant une épaisseur de 2000 angstroem, ces connexions étant séparées du reste du composant par une couche de diélectrique.

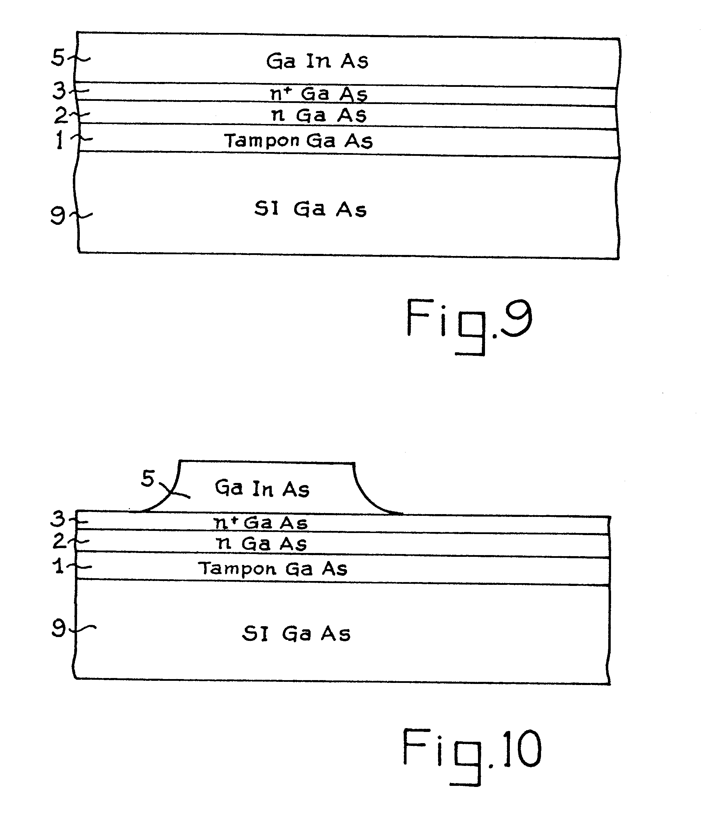

En se reportant aux figures 9 à 14 on va maintenant décrire un exemple de procédé de réalisation selon l'invention de la tête de détection optique qui vient d'être décrite.

Au cours d'une première étape on réalise successivement sur un substrat 9 semi-isolant en arséniure de gallium :

    - une premièce couche 1 d'arséniure de gallium non intentionnellement dopé ou non dopé et d'épaisseur d'environ 4 microns, faisant office de couche tampon ;

    - une deuxième couche 2 d'arséniure de gallium faiblement dopé n avec une concentration de $10^{17}$

atomes par $cm^3$ par exemple, cette couche ayant une épaisseur d'environ 2000 angstroem ;
- une troisième couche 3 d'arséniure de gallium fortement dopé n+ avec une concentration de $10^{18}$ atomes par $cm^3$ par exemple, cette couche ayant une épaisseur d'environ 2000 angstroem ;
- une quatrième couche 5 d'arséniure de gallium et d'indium non intentionnellement dopé et d'épaisseur supérieure à environ 1 micron.

On obtient ainsi une structure représentée en figure 9.

La réalisation de ces différentes couches se fait par une méthode connue de croissance épitaxiale. Notamment, on utilisera une méthode d'épitaxie en phase vapeur, désignée aussi en terminologie anglo-saxonne par MOCVD (Metalorganic Chemical Vapor Deposition). Une telle épitaxie pourra se faire entre 400 et 800 degrés Celsius sous une pression comprise entre 50 millibars et 500 millibars. La vitesse de dépôt sera choisie de façon à obtenir une bonne adaptation entre le matériau épitaxie et le substrat.

Au cours d'une deuxième étape, représentée en figure 10, on procède à une opération de découpe dans la couche 5 d'arséniure de gallium et d'indium d'une mésa correspondant à l'élément photoconducteur à réaliser. Cette découpe peut se faire par attaque ionique.

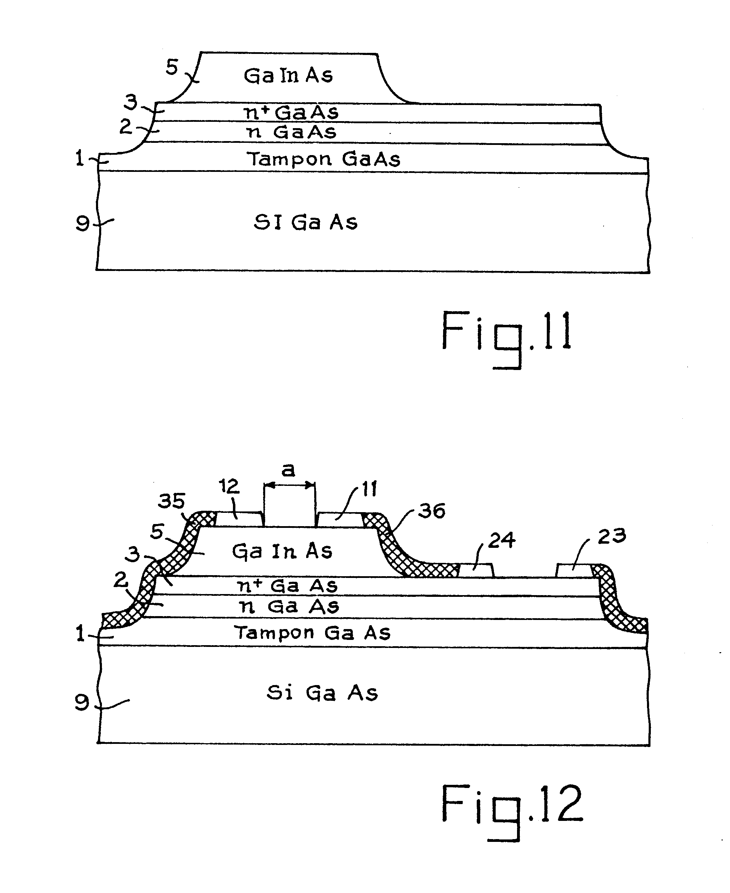

Au cours d'une troisième étape, représentée en figure 11, on réalise une découpe des couches 1, 2 et 3 d'arséniure de gallium de façon à isoler la tête de détection qui doit être réalisée. Cette découpe se fait également par attaque ionique.

Au cours d'une quatrième étape représentée en figure 12, on réalise, sur la couche 5 de la mésa en arséniure de gallium et d'indium, des contacts ohmiques 11 et 12 séparés d'une distance a et des contacts ohmiques 23 et 24 pour la source et le drain du transistor à effet de champ. Un matériau isolant, tel qu'un polyimide, est déposé sous forme d'une couche 35, 36 et assure une isolation des couches d'arséniure de gallium et des contacts entre eux.

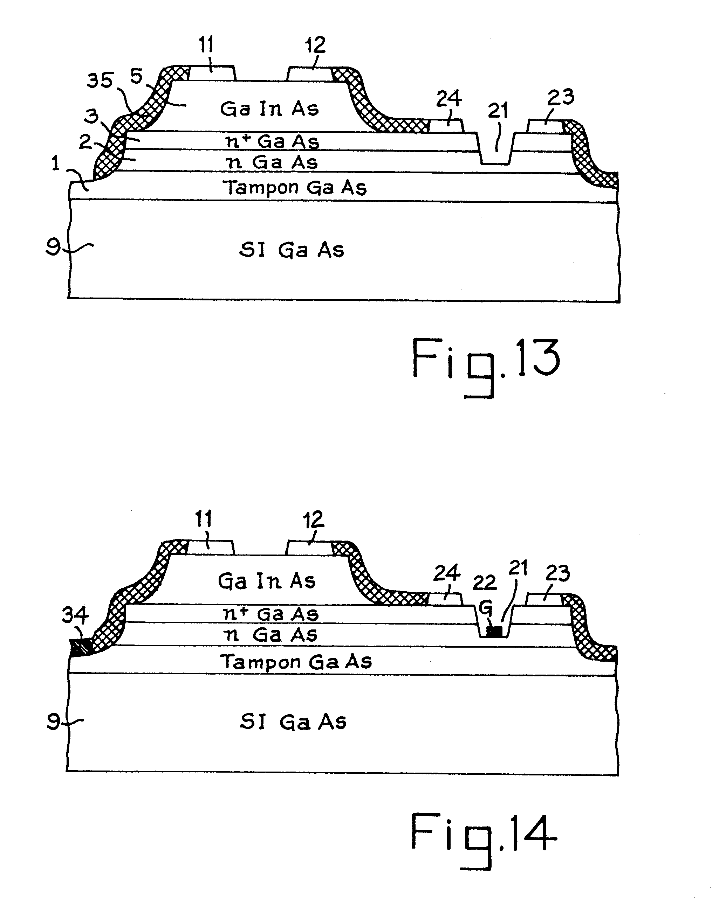

Au cours d'une cinquième étape, représentée en figure 13, on réalise par usinage ionique dans les couches d'arséniure de gallium un creux 21 situé entre la source 24 et le drain 23. Ce creux est destiné à réaliser la porte du transistor à effet de champ. La surface occupée par ce creux est supérieure à 2 $\mu$m $\times$ 900 $\mu$m de façon à pouvoir réaliser une électrode de porte du transistor de cette dimension. Au cours de cette étape, l'isolant 35 est également usiné pour prévoir des connexions extérieures.

Au cours d'une sixième étape, représentée en figure 14, l'électrode de porte 22 est réalisée dans le fond du creux 21. Des connexions extérieures telles que 34 sont également réalisées.

Enfin au cours d'une septième étape, on obtient la tête de détection optique représentée sur la figure 7, par réalisation des connexions 30 et 31 (ou plots d'épaississement) après dépôt d'une couche d'isolant telle qu'un polyimide (non représenté sur la figure).

De cette façon, selon le procédé de l'invention après attaque de la couche de GaInAs, les couches de GaAs ainsi dégagées permettent la fabrication du transistor à effet de champ. Une seconde attaque, jusqu'au GaAs tampon, permet d'isoler les composants les uns des autres. Les connexions entre la photorésistance et le transistor (une électrode de la photorésistance doit être reliée à la source et l'autre à la grille du transistor) sont effectuées par dépôt d'or au-dessus d'une couche diélectrique déposée au-dessus du matériau semi-conducteur. Dans le cas du prototype il s'agit d'un dépôt de polyimide. Ce dépôt permet d'isoler les connexions métalliques des couches actives de GaAs fortement conductrices. Dans le prototype, une compacité maximale du circuit intégré est obtenue en entourant la photorésistance par le transistor à effet de champ. Sur la figure 8, on distingue parfaitement le transistor avec la source, le drain et la grille entourant trois côtés de la photorésistance. La longueur de la grille vaut 2 $\mu$m et la largeur développée 900 $\mu$m. De telles dimensions ont été adoptées de manière à obtenir une transconductance suffisamment grande pour améliorer l'efficacité de la préamplifiation.

Mais, ici encore, d'autres structures de transistors (interdigitées par exemple) peuvent être adoptées, de manière à rendre la préamplification optimale, notamment du point de vue rapport signal sur bruit ; ces autres structures ne modifient en rien le principe de la tête optique.

Il est à noter que la réalisation de la variante de réalisation représentée en figure 3 implique que le procédé de réalisation précédemment décrit prévoit au cours de la première étape, la réalisation d'une couche 4 de phosphore d'indium avant la réalisation de la couche 5 d'arséniure de gallium et d'indium. Par contre l'usinage ionique de cette dernière couche 5 sera alors facilitée par la présence de la couche de phosphore d'indium.

De même, la réalisation de la variante de la figure 6 implique que la première étape du procédé prévoit le dépôt d'une succesison de couches (6, 7, 8) d'arséniure de gallium et d'indium ($Ga_x In_{(1-x)} As$) dont la valeur de x est différente pour les différentes couches 5, 6, 7, 8 comme cela est expliqué précédemment.

Enfin, la variante de réalisation de la figure 4 nécessite, au cours de la première étape, une phase intermédiaire, située avant la réalisation de la couche 5 d'arséniure de gallium et d'indium, durant laquelle un creux 13 prévu pour recevoir l'élément photoconducteur 10 est creusé par usinage ionique dans les couches 1, 2 et 3 d'arséniure de gallium.

Il est à préciser que la variante de réalisation de la figure 4 peut être réalisée avec une couche de phosphore d'indium combinant ainsi les variantes de réalisation des figures 3 et 4. Le procédé de réalisation de la variante de la figure 4 prévoit alors la réalisation d'une couche de phosphore d'indium au cours de la première étape après la réalisation du creux 13 et avant la réalisation de la couche d'arséniure de gallium et d'indium.

De même, la variante de réalisation de la figure 4 peut être réalisée avec une succession de couches intermédiaires 6, 7, 8 d'arséniure de gallium et d'indium telles que décrites en relation avec la figure 6. Le procédé de réalisation devra alors prévoir, au cours de la première étape, la réalisation de ces différentes couches 6, 7, 8 et cela après la réalisation du creux 13. On obtiendra une combinaison des exemples de réalisation des figures 4 et 6.

Ainsi en réalisant selon l'invention, une intégration monolithique du photodétecteur avec l'amplificateur consiste à utiliser des épitaxies spéciales comprenant à la fois des couches de GaAs, permettant la réalisation de transistors à effet de champ, et une couche de GaInAs suffisamment épaisse ($>1$ µm) permettant la photodétection aux longueurs d'onde de 1,3 µm et 1,55 µm.

Les différences de maille cristalline entre le GaAs et le $Ga_{0,47}In_{0,53}As$ impliquent que le matériau ainsi obtenu soit un matériau contraint. Cependant, les travaux récents mettant en oeuvre le procédé de l'invention ont montré la faisabilité de ce type de matériau contraint. En conséquence, il devient désormais possible de réaliser sur un même circuit intégré, une tête de détection optique, complètement intégrée monolithiquement, comprenant un photodétecteur à 1,3 µm et 1,55 µm, et un amplificateur à transistors à effet de champ sur GaAs.

En conclusion, le principal intérêt de la tête de détection de l'invention réside dans la possibilité de réaliser une intégration monolithique planar par hétéroépitaxies pour obtenir des applications dans des longueurs d'ondes de 1,3 µm à 1,55 µm.

En particulier, il est démontré que les hétéroépitaxies ne dégradent pas les performances de bruit des photoconducteurs dans les fréquences avoisiant le gigahertz.

Par ailleurs, l'invention applique des perfectionnements en ce qui concerne :

- la conception d'éléments photoconducteurs réalisés à l'aide d'électrodes interdigitées permettant une meilleure photosensibilité et des temps de transit plus courts ainsi qu'une augmentation du gain ;

- une augmentation de résistance d'obscurité de l'élément photoconducteur par implantation du matériau d'arséniure de gallium et d'indium directement sur la couche tampon d'arséniure de gallium.

Il est bien évident que la description qui précède ne décrit que des exemples de réalisation de l'invention et que les valeurs numériques n'ont été données à titre indicatif que pour illustrer cette description.

## Revendications

1. Tête de détection optique réalisée en optique intégrée comprenant une photorésistance (10) et un amplificateur connecté à cette photorésistance, caractérisée en ce que :

- l'élément photorésistant (10) comporte une couche (5) d'arséniure de gallium et d'indium ($Ga_xIn_{(1-x)}As$) dont la proportion en gallium est de x et celle d'indium de 1-x avec x compris entre 0 et 0,47 de façon à ce que le paramètre de maille de ce matériau soit sensiblement égal à celui du phosphore d'indium, ladite couche (5) d'arséniure de gallium et d'indium étant déposée sur une couche (1) de semiconducteur en arséniure de gallium (GaAs) non intentionnellement dopé.

- l'amplificateur comporte un transistor à effet de champ (20) réalisé sur la couche (1) d'arséniure de gallium (GaAs) non intentionnellement dopé.

2. Tête de détection optique selon la revendication 1, caractérisée en ce que le transistor à effet de champ (20) comporte, sur le substrat (1) une première couche (2) d'arséniure de gallium dopé faiblement d'une première concentration de dopage de type n et une deuxième couche (3) d'arséniure de gallium dopé plus fortement que la couche précédente d'une deuxième concentration de dopage de type n+, une connexion de porte (22) étant connectée à la première couche (2) tandis que les connexions de drain (23) et de source (24) sont connectées à la deuxième couche (3) de part et d'autre de la connexion de porte (22).

3. Tête de détection optique selon la revendication 2, caractérisé en ce que la photorésistance comporte une première électrode (11) connectée à la connexion de porte (22) du transistor à effet de champ (20) et une deuxième électrode (12) connectée à la connexion de source (24).

4. Tête de détection optique selon la revendication 3, caractérisé en ce que la couche (5) d'arséniure de gallium et d'indium (GaInAs) est située sur la deuxième couche (3) d'arséniure de gallium (GaAs).

5. Tête de détection optique selon la revendication 4, caractérisée en ce qu'elle comporte une couche (4) de phosphore d'indium située entre la couche (5) d'arséniure de gallium et d'indium (GaInAs) et la deuxième couche (3) d'arséniure de gallium.

6. Tête de détection optique selon la revendication 1, caractérisée en ce que la couche (5) d'arséniure de gallium et d'indium comporte une proportion x de gallium et une proportion 1-x d'indium, la valeur de x étant de 0,47.

7. Tête de détection optique selon la revendication 1, caractérisée en ce que l'épaisseur de la couche (5) d'arséniure de gallium et d'indium est supérieure à un micromètre.

8. Tête de détection optique selon la revendication 6, caractérisée en ce qu'elle comporte plusieurs couches intermédiaires (6, 7, 8) d'arséniure de gallium et d'indium, la proportion x de gallium par rapport à la proportion 1-x d'indium variant de 0,47 à 1 en passant de la couche (8) la plus proche de la couche (5) d'arséniure de gallium et d'indium vers la couche (6) la plus proche de la première couche (1) en arséniure de gallium.

9. Tête de détection optique selon la revendication 5, caractérisée en ce que la couche (5) de phosphore d'indium a une épaisseur supérieure à 2000 angstroem.

10. Tête de détection optique selon la revendication 8, caractérisée en ce que l'épaisseur de chaque couche intermédiaire (6, 7, 8) d'arséniure de gallium est d'environ cent angstroem.

11. Tête de détection optique selon la revendication 2, caractérisée en ce que l'épaisseur de la première couche (2) d'arséniure de gallium dopé de type n est d'environ 2000 angstroem.

12. Tête de détection optique selon la revendication 2, caractérisé en ce que l'épaisseur de la deuxième couche (3) d'arséniure de gallium dopé de type n+ est d'environ 2000 angstroem.

13. Tête de détection optique selon la revendication 1, caractérisé en ce que le transistor à effet de champ 20 entoure l'élément photoconducteur 10.

14. Procédé de réalisation d'une tête de détection optique selon la revendication 1, caractérisé en ce qu'il comporte les étapes successives suivantes :

- une première étape de réalisation sur un substrat semi-isolant (9) d'une première couche (1) d'arséniure de gallium non intentionnellement dopé, d'une deuxième couche (2) d'arséniure de gallium faiblement dopé, d'une troisième couche (3) d'arséniure de gallium fortement dopé, d'une quatrième couche (5) d'arséniure de gallium et d'indium ($Ga_xIn_{(1-x)}As$) ;

- une deuxième étape de découpe, dans la quatrième couche (5) d'arséniure de gallium et d'indium, d'une mésa ;

- une troisième étape de découpe, dans les trois couches 1, 2 et 3 d'arséniure de gallium, d'un emplacement nécessaire à la réalisation de la tête de détection ;

- une quatrième étape de réalisation, sur la quatrième couche (5) d'arséniure de gallium et d'indium, de contacts ohmiques 11 et 12 et de contacts ohmiques (23, 24) sur la source et le drain du transistor (20), un matériau isolant (35, 36) étant en outre déposé pour isoler les couches d'arséniure de gallium :

- une cinquième étape d'usinage, dans les couches d'arséniure de gallium, entre les contacts ohmiques (23, 24) de source et de drain, d'un creux (21) dont le fond constitue la porte du transistor ;

- une sixième étape de réalisation, dans le fond du creux (21) d'une électrode de porte ((22) ;

- une septième étape de réalisation de connexions (30, 31) entre l'un des contacts ohmiques (12) de l'élément photoconducteur (10) et le contact de source (24), d'une part et, d'autre part, entre l'autre contact ohmique (11) de l'élément photoconducteur (10) et l'électrode de porte (22).

15. Procédé de réalisation selon la revendication 14, caractérisé en ce que la réalisation des différentes couches de la première étape se fait par épitaxie en phase vapeur.

16. Procédé de réalisation selon la revendication 14, caractérisé en ce que les découpes prévues aux deuxième, troisième et cinquième étapes sont réalisées par usinage ionique.

17. Procédé de réalisation selon la revendication 14, caractérisé en ce que les contacts ohmiques (11, 12) réalisés sur la quatrième couche (5) sont de largeur b et distant d'une distance a, ces dimensions a et b déterminant la surface photosensible de l'élément photoconducteur (10).

18. Procédé selon la revendication 14 caractérisé en ce que la première étape prévoit la réalisation d'une couche (4) de phosphore d'indium avant la réalisation de la quatrième couche (5) d'arséniure de gallium et d'indium.

19. Procédé selon la revendication 14, caractérisé en ce que la première étape prévoit, avant la réalisation de la quatrième couche (5), la réalisation de plusieurs couches intermédiaires (6, 7, 8) d'arséniure de gallium et d'indium ($Ga_xIn_{(1-x)}As$), la proportion x de gallium par rapport à la proportion 1-x d'indium variant de 0,47 à 1 en passant de la couche (8) la plus proche de la couche (5) d'arséniure de gallium et d'indium vers la couche (6) la plus proche de la première couche en arséniure de gallium.

20. Procédé selon l'une quelconque des revendications 14, 18 ou 19, caractérisé en ce que la première étape prévoit la réalisation, avant la réalisation de la troisième couche (5), la réalisation d'un creux (13) à l'emplacement où doit être réalisé l'élément photoconducteur (10).

0235029

Fig.1

Fig.2

Fig.3

Fig.4

Fig.5

Fig.6

0235029

Fig.7

Fig.8

Fig.9

Fig.10

Fig.11

Fig.12

11    12

35  5
3
2
1

Ga In As

n⁺ Ga As

n Ga As

Tampon Ga As

9

SI Ga As

24   21   23

**Fig.13**

11    12

Ga In As

n⁺ Ga As

n Ga As

Tampon Ga As

34

9

SI Ga As

24  22  21  23

G

**Fig.14**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | APPLIED PHYSICS LETTERS, vol. 46, no. 7, 1er avril 1985, pages 681-683, American Institute of Physics, New York, US; C.Y. CHEN et al.: "Monolithic integrated receiver front end consisting of a photoconductive detector and a GaAs selectively doped heterostructure transistor" * En entier * | 1-3,14 ,17 | H 01 L  27/14 H 01 L  31/08 |
| | --- | | |
| A | APPLIED PHYSICS LETTERS, vol. 46, no. 4, 15 février 1985, pages 379-381, American Institute of Physics, New York, US; C.Y. CHEN et al.: "2-Gb/s sensitivity of a Ga0.47In0.53As photoconductive detector/GaAs field-effect transistor hybrid photoreceiver" * En entier * | 1,6 | |
| | --- | | |
| A | APPLIED PHYSICS LETTERS, vol. 42, no. 4, 15 février 1983, pages 380-382, American Institute of Physics, New York, US; O. WADA et al.: "Monolithic integration of a photodiode and a field-effect transistor on a GaAs substrate by molecular beam epitaxy" * En entier * | 1-3,14 ,17 | |
| | ---              -/- | | |

**DOMAINES TECHNIQUES RECHERCHES (Int. Cl.4)**

H 01 L

Le présent rapport de recherche a été établi pour toutes les revendications

| Lieu de la recherche | Date d'achèvement de la recherche | Examinateur |
|---|---|---|
| LA HAYE | 22-04-1987 | VISENTIN A. |

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 073 889 (ANT NACHRICHTENTECHNIK GmbH) | | |
| | --- | | |
| A | PATENT ABSTRACTS OF JAPAN, vol. 7, no. 190 (E-194)[1335], 19 août 1983; & JP-A-58 92259 (FUJITSU K.K.) 01-06-1983 | | |
| | --- | | |
| A | INTERNATIONAL ELECTRON DEVICES MEETING - TECHNICAL DIGEST, 5-7 décembre 1983, Washington, DC., pages 475-477, IEEE, New York, US; K. KASAHARA et al.: "Monolithically integrated In0.53Ga0.47As-PIN/InP-MISFET photoreceiver" | | |
| | ----- | | |

DOMAINES TECHNIQUES
RECHERCHES (Int. Cl.4)

Le présent rapport de recherche a été établi pour toutes les revendications

| Lieu de la recherche<br>LA HAYE | Date d'achèvement de la recherche<br>22-04-1987 | Examinateur<br>VISENTIN A. |
|---|---|---|

OEB Form 1503. 03.82